# FASCICULE DE BREVET EUROPEEN

(11) **EP 3 440 692 B1**
(45) Date de publication et mention de la délivrance du brevet: **29.07.2020**
(21) Numéro de dépôt: 17711720.7
(22) Date de dépôt: 01.03.2017
(51) Int. Cl.: H01L 21/20

(54) **STRUCTURE SEMI-CONDUCTRICE A BASE DE MATERIAU III-N**
HALBLEITERSTRUKTUR MIT III-N-MATERIAL
SEMICONDUCTOR STRUCTURE COMPRISING III-N MATERIAL

(30) Priorité: 05.04.2016 FR 1652983
(43) Date de publication de la demande: 13.02.2019
(73) Titulaire: Exagan, 38040 Grenoble Cedex 9 (FR)
(72) Inventeur: SCHENK, David, 38600 Fontaine (FR); BAVARD, Alexis, 38360 Sassenage (FR)
(74) Mandataire: IP Trust
(86) Numéro de dépôt international: PCT/FR2017/050467
(87) Numéro de publication internationale: WO 2017/174885

(56) Documents cités:
- EP-A1- 2 767 620
- WO-A1-02/29873
- US-A1- 2006 191 474
- US-B2- 8 405 064
- FELTIN ERIC ET AL: "Stress control in GaN grown on silicon (111) by metalorganic vapor phase epitaxy", APPLIED PHYSICS LETTERS, A I P PUBLISHING LLC, US, vol. 79, no. 20, 12 novembre 2001 (2001-11-12), pages 3230-3232, XP012029401, ISSN: 0003-6951, DOI: 10.1063/1.1415043

## Description

### DOMAINE DE L'INVENTION

La présente invention concerne une structure semi-conductrice à base de matériaux III-N.

### ARRIERE PLAN TECHNOLOGIQUE DE L'INVENTION

Les structures semi-conductrices à base de matériaux III-N sont notamment utiles pour recevoir des transistors du type HEMT (« High Electron Mobility Transistor » selon la terminologie anglo-saxonne ou transistor à haute mobilité d'électrons) qui trouvent leur application par exemple comme interrupteur dans les convertisseurs de puissance.

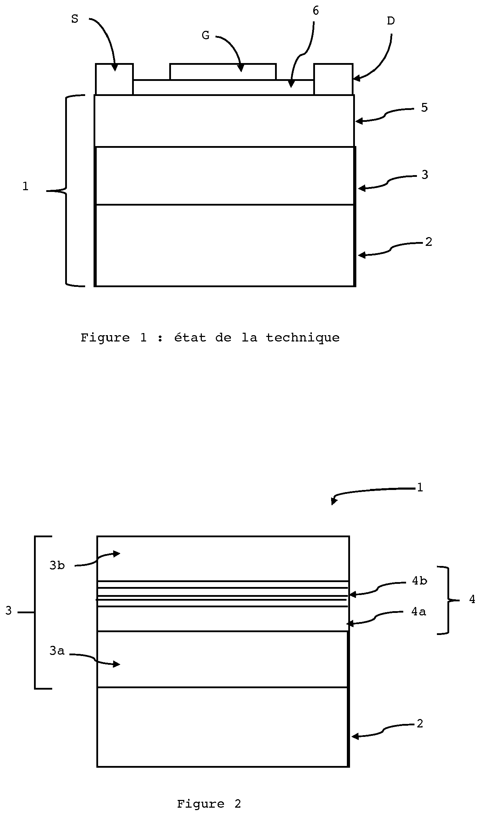

On connaît du document « High electron mobility transistor based on a GaN-AlGaN heterojunction » M.A. Kahn et al., Applied Physics Letters, Vol. 63, N°9 du 30 août 1993, une structure semi-conductrice 1 munie d'un tel transistor HEMT. Comme cela est représenté schématiquement sur la figure 1, cet ensemble est composé :
- d'un substrat de saphir 2 et d'une couche principale d'AlN 3 formant la structure semi-conductrice 1 ;
- d'une hétérojonction constituée d'une couche canal 5 en GaN et d'une couche barrière 6 d'AlGaN formées successivement sur la structure semi-conductrice ;
- d'électrodes de source S, de drain D et de grille G sur/dans l'hétérojonction.

L'état électriquement passant du transistor entre la source S et le drain D est commandé par la tension appliquée à la grille G.

Ainsi, lorsque la tension appliquée sur la grille G excède une tension seuil Vt, le transistor est passant. Dans le cas d'application de puissance, plusieurs ampères voire plusieurs dizaines d'ampères peuvent circuler dans la couche canal entre la source S et le drain D. La tension V_{DS} qui se développe dans ce cas entre ces deux électrodes est de l'ordre de quelques volts à quelques dizaines de volts, et est liée à la résistivité du matériau de la couche canal.

Lorsque la tension appliquée sur la grille G est inférieure à la tension seuil Vt, le transistor est bloquant. Dans le cas d'application de puissance, la tension V_{DS} qui s'applique aux bornes des électrodes de source S et de drain D peut alors atteindre quelques centaines de volts à quelques milliers de volts. Le courant de fuite circulant entre la source S et le drain D est faible, de l'ordre de quelques nanoampères par mm de largeur de grille.

En contrôlant la tension de grille, le transistor peut être commuté très rapidement (en quelques nanosecondes) entre un état passant et un état bloquant.

Plusieurs problèmes limitent toutefois la diffusion de cette technologie.

Comme on l'a vu, à l'état bloquant, une forte tension s'applique aux bornes des électrodes de source S et de drain D. Cela conduit à la formation d'un champ électrique dont les lignes pénètrent très en profondeur dans la couche principale 3 et le substrat 2. Un champ électrique qui peut être d'intensité importante se développe alors entre l'électrode de drain D et le substrat 2, notamment dans l'épaisseur de la couche principale 3, et entre la source S et le drain D. Afin d'éviter que l'intensité de ce champ n'excède la valeur critique (appelée champ de claquage) au-delà duquel le matériau ne peut plus le soutenir, on doit prévoir de séparer le drain D et la source S d'une distance suffisante d pour que, pour une tension donnée V_{DS}, l'intensité du champ E = V_{DS}/d soit inférieur au champ de claquage. De la même manière, on doit prévoir de fournir une couche principale 3 d'épaisseur suffisante pour que la tension qui se développe entre le substrat 2 et le drain D (qui peut être de l'ordre de V_{DS}) conduisent à une intensité du champ dans les matériaux en jeu qui soit également inférieure au champ de claquage.

Il est relativement aisé de choisir la distance d séparant l'électrode de drain D de la source S lors de la conception du transistor. Ainsi, pour une tension V_{DS} de l'ordre de 400 V à 2000 V, on peut choisir une distance d de l'ordre de 5 à 20 microns.

Fournir une structure semi-conductrice 1 présentant une couche principale 3 en matériaux III-N suffisamment épaisse (de l'ordre de 3 microns ou plus) est toutefois bien plus difficile, notamment lorsque le substrat 2 est choisi en silicium plutôt qu'en saphir, pour des raisons de disponibilité et de coût.

À ce titre, les documents EP1290721 et WO2013001014 fournissent des exemples de techniques connues permettant de faire croître une couche principale 3 épaisse d'un matériau III-N sur un substrat 2 qui peut être en silicium. Ces techniques comprennent l'insertion dans la couche tampon en matériaux III-N d'au moins une couche intercalaire, également en matériau III-N, dont la nature est choisie pour mettre en compression une partie de la couche tampon avec laquelle elle est en contact.

Un autre problème qui limite la diffusion de la technologie, concerne le courant de fuite circulant, dans l'épaisseur de la couche principale 3, entre la source S et le drain D lorsque le transistor est à l'état bloquant. Bien entendu, on souhaiterait que ce courant soit le plus petit possible. C'est pourquoi la couche principale 3 est généralement dopée à l'aide d'un dopant de type p, tel que du fer, du carbone ou du magnésium, pour la rendre résistive et limiter de la sorte la circulation des courants de fuite.

L'expérience montre toutefois que malgré ce dopage résistif, la structure 1 peut présenter un courant de fuite excessif pour les applications visées.

US 8 405 064 B2 décrit des structures épitaxiales de GaN sur Si, où des super-réseaux de AlN/GaN sont insérés pour induire une contrainte compressive qui contre la contrainte en tension causée par la différence entre les coefficients de dilatation thermique des nitrures de groupe III et du Si.

EP 2 767 620 A1 voir figure 2 décrit des structures épitaxiales de GaN sur Si, avec une couche intercalaire 230 ciblant la réduction des contraintes en tension induites par l'inadéquation de l'expansion thermique entre le film de nitrure III et le substrat de Si. Le document enseigne l'emploi de dopage avec du carbone ou du magnésium dans la couche intercalaire pour combattre la formation de canaux conductifs parasitaires. Le document (voir paragraphe [0050]) enseigne aussi l'emploi d'un super-réseau 250 dopé avec du carbone comme couche tampon entre l'hétéro-substrat et la couche principale 220-240.

On connaît également des documents « Stress control in GaN grown on silicon (111) by metalorganic vapor phase eptitaxy », de E. Feltin et al., Applied Physics Letters, Vol. 79, n°20 du 12 novembre 2001 ; US2006191474 et WO0229873 différentes techniques de croissance d'une couche principale en un matériau III-N sur un substrat qui peut être en silicium. Ces techniques prévoient l'insertion, dans la structure formée, d'un super-réseau et observent une amélioration de la qualité cristalline de la couche principale, et notamment de sa densité de dislocation. Mais ces documents ne traitent aucunement du problème du courant de fuite pouvant se former dans l'épaisseur de la structure, ce problème reste donc posé.

### OBJET DE L'INVENTION

La présente invention vise à pallier tout ou partie des inconvénients précités. Elle vise en particulier à fournir une structure semi-conductrice présentant, sur un substrat support, une couche principale épaisse et très résistive afin de pouvoir former un transistor pouvant supporter des tensions importantes, et limitant l'intensité des courants de fuite.

### BREVE DESCRIPTION DE L'INVENTION

En vue de la réalisation de l'un de ces buts, l'objet de l'invention propose une structure semi-conductrice à base de matériaux III-N selon la revendication 1; et son procédé de fabrication selon la revendication 9.

### BREVE DESCRIPTION DES DESSINS

D'autres caractéristiques et avantages de l'invention ressortiront de la description détaillée de l'invention qui va suivre en référence aux figures annexées sur lesquelles :
- la figure 1 représente une structure semi-conductrice munie d'un transistor HEMT selon l'état de la technique ;
- la figure 2 représente une structure semi-conductrice à base de matériaux III-N conforme à l'invention;
- la figure 3 représente une autre structure semi-conductrice à base de matériaux III-N conforme à l'invention;
- la figure 4 illustre graphiquement les performances en courant de fuite d'une structure semi-conductrice conforme à l'invention.

### DESCRIPTION DETAILLEE DE L'INVENTION

Par souci de simplification de la description à venir, les mêmes références sont utilisées pour des éléments identiques ou assurant la même fonction dans les différents modes de mise en œuvre de l'invention ou dans l'exposé de l'état de la technique.

La figure 2 représente une structure semi-conductrice 1 à base de matériaux III-N conforme à l'invention.

La structure semi-conductrice 1 peut prendre la forme d'une plaquette de semi-conducteur circulaire de dimension normalisée par exemple de 150 mm, 200 mm voire même 300 mm. Mais l'invention n'est nullement limitée à cette forme ou à ces dimensions. Ainsi, dans le cas où la structure semi-conductrice 1 fait partie d'un dispositif intégré singularisé, fini ou semi-fini, elle prendra la forme d'un bloc de matériau, rectangulaire ou carré, de quelques millimètres à quelques centimètres de côté, aux dimensions du dispositif intégré.

Quelle que soit sa forme, la structure semi-conductrice 1 comprend un substrat support 2 apte à recevoir des couches cristallines en matériau III-N, par épitaxie. Pour des raisons de coût et de disponibilité, le substrat support 2 est avantageusement en silicium monocristallin, et de préférence d'orientation cristalline (111). Mais l'invention n'est pas limitée à ce matériau et à cette orientation, alternativement, il peut s'agir de carbure de silicium, de nitrure de gallium massif, de silicium (110) ou (001) ou encore d'un substrat avancé du type silicium sur isolant ou carbure de silicium sur isolant.

La structure 1 comprend également, sur le substrat support 2, une couche principale 3 monocristalline en matériau III-N. Par matériau III-N, on entend tout matériau, alliage ou empilement de matériau ou d'alliage de la forme générique B_{w}AlₓGa_{y}In_{z}N avec w+x+y+z=1. La couche principale 3 comporte une première section 3a disposée sur le support 2 et une seconde section 3b disposée sur la première section 3a.

La nature de la couche principale 3 n'est pas nécessairement identique sur toute son épaisseur. Ainsi, les sections 3a, 3b peuvent présenter des compositions différentes l'une de l'autre. Par ailleurs, chaque section 3a, 3b peut également être composée d'une pluralité de sous-couches de composition ou de nature différentes les unes des autres.

La couche principale 3 fournit une épaisseur de matériau permettant d'éloigner du substrat support 2 un dispositif intégré formé sur la structure 1. On limite ainsi l'intensité du champ électrique qui se développe entre le substrat support 2 et l'électrode de source S ou de drain D, pour une tension donnée, lorsque ce dispositif est en fonctionnement.

De manière avantageuse, l'épaisseur de la couche principale 3 (c'est-à-dire l'épaisseur de matériau comprise entre la face supérieure du substrat support 2 et la face libre de la structure semi-conductrice 1) est supérieure à 3 microns, ou 5 microns ou 10 microns. Une épaisseur importante permet de former sur la structure semi-conductrice 1 un dispositif intégré qui peut être soumis à une tension importante sans risquer de claquer (supérieure par exemple à 1000 V).

Préférentiellement, et afin de limiter les courants de fuite pouvant circuler dans la structure 1 lorsque celle-ci est munie d'un dispositif intégré, la couche principale 3 est dopée pour la rendre résistive. Il peut s'agir par exemple d'un dopage au carbone dont la concentration dans la couche principale peut être comprise entre 5×10^18 et 5×10^19 at/cm^3. Il peut s'agir également d'un autre dopage de type p, par exemple au fer ou au magnésium.

Cette concentration n'est pas nécessairement uniforme dans la couche principale 3 et dans les sections de la couche principale 3a, 3b. Elle peut varier au sein de cette couche et/ou de ces sections 3a, 3b, notamment selon une direction perpendiculaire au substrat support 2.

A titre d'exemple, la section 3a de la couche principale 3 qui est en contact avec le substrat support 2 peut comprendre en contact avec ce support 2 une première sous-couche de nucléation de quelques centaines de nm d'épaisseur, par exemple en AlN (non représenté sur la figure 2), facilitant l'épitaxie du reste de la couche principale 3 sur le substrat support 2. Cette sous-couche de nucléation en AlN est particulièrement utile lorsque le support 2 est en silicium. La section 3a peut également comprendre, sur la sous-couche de nucléation, une ou plusieurs autres sous-couches, par exemple du GaN ou de AlGaN, de composition homogène ou sous la forme de super réseau (ces termes seront définis ultérieurement).

Comme cela est rappelé dans les documents présentés de l'état de la technique, la différence des coefficients de dilatation thermique pouvant exister entre le substrat support 2 et la couche principale 3 monocristalline peut conduire à la génération de contraintes importantes dans ces éléments au cours de la formation en température de la couche principale 3 et/ou suite à sa formation, et tout particulièrement lors du refroidissement de la structure. Lorsque le substrat support 2 présente un coefficient de dilatation thermique inférieur à celui de la couche principale 3, cette couche est soumise, après sa formation en température et son retour à température ambiante, à des contraintes extensives pouvant conduire à sa fissuration. C'est notamment le cas lorsque la couche principale 3 présente une épaisseur supérieure à quelques microns.

Afin de limiter cet effet et prévenir l'apparition de fissures dans la couche principale 3 qui rendraient la structure semi-conductrice 1 inapte à recevoir un dispositif intégré, l'invention prévoit, intercalée dans la couche principale 3, une couche intercalaire 4 monocristalline en matériau III-N disposée entre la première section 3a et la seconde section 3b. Cette couche intercalaire 4 est configurée pour mettre en compression la seconde section 3b de la couche principale 3, au cours de sa formation en température (par épitaxie). Cette compression compense lors du retour à température ambiante les contraintes extensives pouvant conduire à sa fissuration lorsque le substrat support 2 présente un coefficient de dilatation thermique inférieure à la couche principale 3.

Selon l'invention, la couche intercalaire 4 est composée d'une couche inférieure 4a disposée sur la première section 3a de la couche principale 3 et d'une couche supérieure 4b disposée sur, et en contact avec, la couche inférieure 4a.

Pour permettre la mise en compression efficace de la seconde section 3b de la couche principale 3, la nature et la composition de la couche intercalaire 4 sont choisies pour que le paramètre de maille du matériau formant la couche inférieure 4a soit plus petit que le paramètre de maille du matériau formant la couche supérieure 4b. Celui-ci est choisi pour être plus petit que le paramètre de maille du matériau formant la seconde section 3b. Pour la même raison de mise en compression efficace de la seconde section 3b de la couche principale 3, la couche supérieure 4b est directement en contact avec la couche inférieure 4a. Par souci de clarté, on précise que l'expression « paramètre de maille d'une couche de matériau» désigne le paramètre de maille du matériau, dans le plan défini par la couche.

La couche inférieure 4a peut être constituée d'une couche de composition homogène. Alternativement, elle peut être constituée d'un super réseau. Dans les deux cas, cette couche inférieure 4a a pour fonction principale de mettre en compression la seconde section 3b de la couche principale 3. Pour favoriser cette mise en compression, et comme cela est rappelé dans le document US2006/0191474 de l'état de la technique, la couche inférieure 4a est formée à une première température relativement basse, par exemple inférieure à 1000°C. En conséquence, elle présente une qualité cristalline moindre, et présente notamment une concentration de dislocations traversantes pouvant atteindre 10^10 ou 10^11/cm^2, comme cela peut être déterminé par une analyse TEM ou SEM. Cette concentration est bien supérieure à la concentration de dislocations présente dans des couches obtenues à une seconde température plus conventionnelle, supérieure à 1000°C et typiquement comprise entre 1050°C et 1100°C environ lors de la formation par MOCVD de couches en matériaux III-N. Ces dislocations forment des passages privilégiés pour le courant, et conduisent donc à réduire la résistivité électrique de la structure.

C'est pourquoi, selon l'invention, la couche intercalaire 4 comprend également une couche supérieure 4b, constituée d'un super réseau. La couche supérieure 4b est formée à une seconde température plus conventionnelle, supérieure à la première température. Elle peut être ainsi supérieure à 1000°C, et typiquement comprise entre 1050°C et 1100°C. La couche supérieure 4b présente une densité de dislocation inférieure à celle de la couche inférieure 4a. Outre sa contribution à la mise sous contrainte de la seconde section 3b de la couche principale, la couche supérieure est particulièrement efficace pour améliorer les propriétés électriques de l'empilement et compenser les défauts électriques de la couche inférieure 4a sur laquelle elle repose.

Par « super réseau », et selon la définition usuelle dans le domaine du semi-conducteur, on entend un empilement périodique de couches de faible épaisseur, par exemple comprises entre 0,5 et 20 nm, voire même 50nm. Comme cela est bien connu en soi, une couche formée en super réseau est assimilable, macroscopiquement, à une couche de composition homogène, comme cela peut être révélé par une analyse en diffraction aux rayons, par photo- ou par cathodoluminescence. On précise que le paramètre de maille d'une couche en super réseau correspond au paramètre de maille de la couche homogène équivalente (dont la composition peut être révélée par diffraction aux rayons X, par photo- ou par cathodoluminescence).

Similairement à ce qui avait été exposé pour la couche principale 3, et pour les mêmes raisons, la couche inférieure est avantageusement dopée (type p) pour les rendre résistives. Il peut s'agir d'un dopage carbone, fer ou magnésium dans une concentration qui peut être comprise entre 5×10^18 et 5×10^19 at/cm^3. Selon l'invention, la couche supérieure, disposée sur la couche inférieure, est constituée d'un super réseau (AlGaN/GaN super lattice) et comprend un dopant de type p de carbone, de fer ou de magnésium dans une concentration comprise entre 5X 10¹⁸ et 5X 10¹⁹ at/cm³.

Selon l'invention, la couche intercalaire 4 présente une épaisseur qui peut être comprise entre 200 nm et 1000nm afin de conserver la mise en compression effective des parties de la section 3b de la couche principale 3, sans nécessiter une épaisseur excessive. D'une manière générale, chacune des couches supérieure et inférieure 4a, 4b peut présenter une épaisseur comprise entre 10 et environ 1000 nm.

Dans le cas où à la fois la couche inférieure 4a et la couche supérieure 4b sont des super réseaux, celles-ci présentent des densités de dislocations traversantes différentes, de sorte qu'il est bien possible de distinguer deux couches distinctes l'une de l'autre dans l'empilement.

Former la couche supérieure 4b sous la forme de super réseau plutôt que sous la forme d'une couche homogène présente de nombreux avantages.

Tout d'abord, la demanderesse a observé qu'il était possible de doper fortement cette couche (par exemple avec du carbone et dans la gamme précitée de concentration de 5×10^18 à 5×10^19 at/cm^3) sans endommager la qualité cristalline de ces couches.

Il est en effet parfois observé qu'une concentration importante de dopant dans une couche homogène de matériau III-N, peut conduire à former des trous ou d'autres défauts morphologiques de surface. Ces défauts ont pour conséquence de rendre la structure semi-conductrice qui les contient inapte à recevoir un dispositif intégré, et notamment un dispositif de puissance, performant. Ils conduisent à des courants de fuite importants et une tension de claquage réduite.

La couche supérieure 4b réalisée sous la forme de super réseaux prévient l'apparition de ces défauts même lorsque ces couches sont dopées à forte concentration. Selon l'invention au moins cette couche est dopée à forte concentration avec un dopant de type p de carbone, de fer ou de magnésium dans une concentration comprise entre 5X 10¹⁸ et 5X 10¹⁹ at/cm³. On peut alors fournir une couche intercalaire 4 et une structure semi-conductrice 1 très résistive qui limitent les courants de fuite d'un dispositif intégré formé sur cette structure 1.

De plus, les nombreuses interfaces qui composent l'empilement de couches formant le super réseau apparaissent bénéfiques à l'isolation et la limitation des courants de fuites de la structure semi-conductrice 1. Elles préviennent ou limitent notamment l'apparition d'un plan électronique conducteur (qui favorise l'écoulement de courants de fuite) sous la couche supérieure 4b (et sous la couche inférieure 4a lorsque celle-ci est formée d'un super réseau) qui apparaît parfois lorsque la couche intercalaire 4 est constituée d'une couche homogène (formant hétérojonction avec la couche sous-jacente) de l'état de la technique. D'une manière générale, la couche supérieure 4b en super réseau forme une barrière efficace aux porteurs libres de la structure semi-conductrice.

D'une manière générale, le super réseau constituant la couche supérieure 4b et, le cas échéant, la couche inférieure 4a, peut être formé d'une répétition d'un motif, le motif comprenant au moins deux couches. La première couche présente la forme générale Al_{w1}GaNₓ₁In_{y1}B_{z1}N avec w1+x1+y1+z1=1 et la deuxième couche présente la forme générale Al_{w2}GaNₓ₂In_{y2}B_{z2}N avec w2+x2+y2+z2=1. Les natures des deux couches sont différentes c'est-à-dire que deux au moins des couples (w1, w2) ; (xl, x2) ;(y1, y2) ; (z1, z2) sont différents.

Chaque couche composant le motif présente une très faible épaisseur, selon l'invention comprise entre 0,5 nm et 50 nm. De préférence, on choisira ces épaisseurs de couches de manière à être inférieure à leurs épaisseurs critiques et limiter la formation de dislocations. Mais l'invention n'est pas limitée à cette forme de super réseau, et on pourra prévoir un certain degré de relaxation dans les couches. Par ailleurs, les épaisseurs des couches du motif peuvent être identiques entre elles ou différentes.

Le motif constituant la couche supérieure 4b peut être répété de 2 à 500 fois, suivant les épaisseurs respectives des couches qui la compose, de sorte à former une couche supérieure 4b d'épaisseur comprise entre 10 et environ 1000 nanomètres. Il en va de même pour le motif constituant la couche inférieure 4a, lorsque celle-ci est formée d'un super réseau.

La couche intercalaire 4 est préférentiellement placée centralement dans l'épaisseur de la couche principale 3, c'est-à-dire que les épaisseurs de la première section 3a et de la seconde section 3b peuvent être sensiblement identiques (à 50% près). On contrôle ainsi de manière efficace les contraintes qui se développent dans le matériau au cours de sa fabrication.

À titre d'exemple, on peut prévoir d'insérer la couche intercalaire 4 dans la couche principale 3 de sorte que les sections 3a, 3b présentent chacune une épaisseur inférieure à 2 microns, 2,5 microns ou encore 3 microns.

La structure semi-conductrice 1 peut présenter plus d'une couche intercalaire, notamment lorsque l'épaisseur de la couche principale 4 est importante, en particulier supérieure à 5 microns.

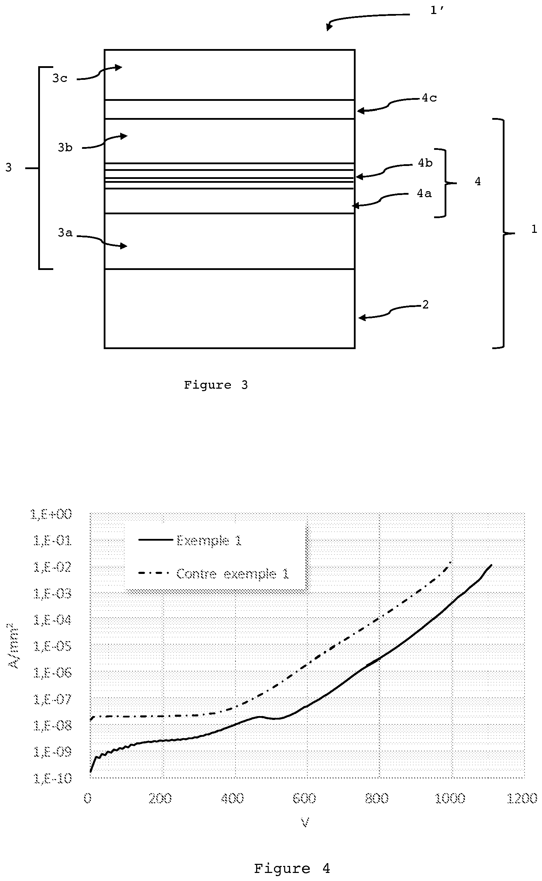

Ainsi, la figure 3 représente une structure semi-conductrice 1' comprenant une structure 1 en tout point similaire à celle représentée sur la figure 2 qui vient d'être décrite en détail. Sur cette structure 1, et plus précisément sur la seconde section 4b de la couche principale, on a formé une seconde couche monocristalline intercalaire 4c, sur laquelle est disposée une troisième section 3c de la couche principale 3 monocristalline. La seconde couche intercalaire 4c met en compression la troisième section 3c de la couche principale. Le matériau qui compose la seconde couche intercalaire présente un paramètre de maille inférieur au matériau qui compose la troisième section 3c de la couche principale.

La seconde couche intercalaire 4c peut prendre toute forme adaptée : elle peut être composée ou constituée d'une couche homogène, d'un super réseau, ou d'une combinaison de tels éléments. Elle peut notamment être composée d'une couche inférieure et d'une couche supérieure similairement à ce qui a été décrit en relation avec couche intercalaire 4.

On pourra empiler autant de fois que nécessaire, sur la structure semi-conductrice 1, une structure composée d'une couche intercalaire 4c et d'une section 3c pour former une couche principale 3 d'épaisseur importante et de qualité cristalline satisfaisante.

Quel que soit l'empilement choisi, la structure semi-conductrice 1, 1' de l'invention est réalisée par croissance, par exemple par épitaxie en phase vapeur (« Metal Organic Chemical Vapor Déposition » selon la terminologie anglo-saxonne) ou par épitaxie par jets moléculaires (« Molecular Beam Epitaxy » selon la terminologie anglo-saxonne).

Pour procéder à la croissance de la couche principale 3 et des couches intercalaires 4a, 4b, 4c on place le substrat support 2 (ou une pluralité de substrats supports) dans une chambre de dépôt d'un équipement conventionnel.

Comme cela est bien connu en soi, le substrat support 2 peut être préparé avant dépôt pour éliminer une couche d'oxyde natif de sa surface.

Dans le cas d'un dépôt selon la technologie MOCVD, la chambre est traversée par des flux de gaz précurseur et porteur, en température typiquement comprise entre 1050°C et 1150°C pour la plupart des couches composant la structure, et maintenue à une pression de l'ordre de 100 mbar, et typiquement compris entre 50 et 200 mbar. Les conditions de croissance, c'est à dire la température, la pression, les flux de gaz permettent de choisir la composition, la qualité et l'épaisseur de chaque élément de l'empilement formant la structure 1, 1'. Comme on l'a vu précédemment, la couche inférieure 4a est formée à une première température relativement basse, inférieure à la température de formation de la couche supérieure 4b, de manière à favoriser la mise sous contrainte de la deuxième section 3b de la couche principale 3. Les autres couches de la structure, et notamment la couche supérieure 4b de la couche intercalaire 4 est formée à une température relativement élevée, de l'ordre de 1050°C à 1100°C. A titre d'exemple, le gaz précurseur de l'élément Ga peut être du tri-méthylgallium (de composition Ga(CH₃)₃) ou du tri-éthylgallium (de composition Ga(C₂H₅)₃) ; le gaz précurseur de l'élément Al peut être du tri-méthylaluminium (de composition Al₂(CH₃)₆) ou de tri-éthylaluminium (de composition Al₂(C₂H₅)₆), le précurseur de l'élément III peut être de l'ammoniac (NH3) ; et le gaz porteur peut comprendre ou être constitué d'hydrogène et/ou d'azote.

Lorsqu'au moins un gaz précurseur est carboné, comme ceux qui ont été listés à titre d'exemple ci-dessus, les conditions de croissance permettent également de contrôler la proportion de carbone qui s'incorpore dans les couches au cours de la croissance pour les doper intrinsèquement. Alternativement, on peut utiliser une source de dopage extrinsèque de type p additionnelle pour rendre certaines couches résistives. Il peut s'agir de source de dopant au fer, au carbone ou encore au magnésium. Dans le cas d'un dopage au carbone, la source de dopage extrinsèque peut être du CCl₄, CBr₄, C2H2, C2H4, C6H12, etc.

### Exemple 1

Dans une chambre de dépôt d'un réacteur MOCVD de type Aixtron ou Veeco, on place une plaquette de 200 mm de silicium 111. On forme tout d'abord sur cette plaquette une couche de nucléation d'AlN de 100 à 300 nm d'épaisseur. Puis on forme une couche principale de 5 microns de GaN sur la couche de nucléation. Intercalés dans cette couche principale, on a formé, à deux microns du support, une couche intercalaire 4. Cette couche intercalaire est constituée d'une couche inférieure 4a de constitution homogène d'AlN de 17 nm d'épaisseur. Cette couche présente une densité de dislocation supérieure à 10^10/cm^2. Sur cette couche inférieure 4a, on forme une couche supérieure 4b sous la forme d'un super réseau composé de 100 répétitions d'un motif formé d'une première couche de AlGaN présentant une concentration d'Al de 20% de 1 nm d'épaisseur, et d'une seconde couche de GaN de 1 nm d'épaisseur. Cette couche présente une densité de dislocation inférieure à 10^10/cm^2.

La couche intercalaire 4 présente donc une épaisseur de 217 nm et la couche supérieure 4b en super réseau est assimilable macroscopiquement à une couche d'AlGaN homogène dont la teneur en aluminium est de 10 %. La couche d'AlN formant la couche inférieure et, dans une certaine mesure, le super réseau formant la couche supérieure 4b, présentent un paramètre de maille plus petit que celui du GaN constituant la couche principale 3 et permettent de maintenir en compression la section de cette couche principale 3.

Dans cet exemple, la couche principale 3 et les couches intercalaires 4a, 4b sont toutes dopées en carbone, dans une concentration de l'ordre de 10^19 at/cm^3 au cours de leurs croissances. La couche principale 3 de GaN présente une qualité cristalline satisfaisante, elle ne présente notamment pas de fissure qui la rendrait inapte à recevoir un dispositif intégré.

### Exemple 2

Cet exemple est identique à l'exemple précédent, mais cette fois la couche intercalaire est constituée d'une couche inférieure 4a en super réseau. Ainsi, la couche inférieure 4a est composée de 10 répétitions d'un motif formé d'une première couche de AlN de 1 nm d'épaisseur et d'une seconde couche de GaN de 0,5 nm d'épaisseur. La couche inférieure 4a en super réseau est assimilable macroscopiquement à une couche d'AlGaN homogène de 15 nm d'épaisseur dont la teneur en aluminium est de 66 %.

### Exemple 3

Cet exemple concerne une structure semi-conductrice présentant deux couches intercalaires. Dans l'exemple 3, on forme sur la structure semi-conductrice de l'exemple 1 une seconde couche intercalaire constituée d'une couche homogène d'AlGaN présentant une concentration de 80% d'aluminium et d'épaisseur 20 nm. Sur la couche d'AlGaN on forme une troisième section de GaN présentant 1 micron d'épaisseur.

### Exemple 4

Cet exemple est une structure alternative à celle présentée à l'exemple 3. Dans cet exemple 4, la seconde couche intercalaire est constituée d'un super réseau. Le super réseau est formé de 5 répétitions d'un motif formé d'une couche d'AlN de 2 nm et d'une couche d'AlGaN (60% d'Al) de 2 nm.

### Contre exemple 1

Ce contre-exemple est similaire à la structure de l'exemple 1 dans laquelle la couche supérieure 4b en super réseau a été remplacée par une couche supérieure homogène d'AlGaN (de teneur en Aluminium de 10%) de 200 nm. En d'autres termes, la seule différence entre la structure semi-conductrice de l'exemple 1 et du contre-exemple 1 est que dans l'exemple 1 la couche supérieure est réalisée sous la forme d'un super réseau, et que dans le contre-exemple 1, la couche supérieure est réalisée sous la forme d'une couche homogène.

La figure 4 illustre graphiquement les performances en densité de courant de fuite de la structure de l'exemple 1 et de la structure du contre-exemple 1.

L'axe des abscisses représente une tension verticale (exprimée en volts) appliquée de part et d'autre de la structure, c'est à dire entre d'une part la face libre du substrat support 2 et d'autre part la face libre de la couche principale 3. L'axe des ordonnées représente la densité de courant circulant entre ces deux surfaces (exprimée en Ampère/mm^2 et sur une échelle logarithmique).

La densité de courant de fuite suivant la tension appliquée dans le cas de la structure semi-conductrice de l'exemple 1 est représentée sur ce graphe par le trait plein. La densité de courant de fuite suivant la tension appliquée dans le cas de la structure semi-conductrice du contre-exemple 1 est représentée sur ce graphe par le trait pointillé. Les mesures ont été réalisées à température ambiante.

On observe que la structure de l'exemple 1 permet de gagner environ une décade de densité de courant, quelle que soit la tension appliquée jusqu'au moins 1000 Volts. On comprend donc qu'un dispositif intégré (tel qu'un dispositif HEMT) présentant une géométrie déterminée formé sur la structure de l'exemple 1 présentera un courant de fuite environ dix fois moindre que le même dispositif, présentant donc la même géométrie, et formé sur la structure du contre-exemple 1.

Bien qu'on ait illustré les bénéfices de la structure semi-conductrice 1 dans une application de puissance lorsqu'elle est munie d'un dispositif intégré de type HEMT, l'invention n'est nullement limitée à cette application ou à ce type de dispositif. Ainsi, on pourra tirer profit de la structure semi-conductrice 1 de l'invention dans le domaine des radiofréquences, des diodes électroluminescentes et pour tout autre application ou dispositif pour lesquels les propriétés électriques présentées sont avantageuses.

## Revendications

1. Structure semi-conductrice (1) à base de matériaux III-N comprenant :
• un substrat support (2) ;
• une couche principale (3) en matériau III-N, la couche principale (3) comportant une première section (3a) disposée sur le substrat support (2) et une seconde section (3b) disposée sur la première section (3a);
• une couche intercalaire (4) en matériau III-N disposée entre la première section (3a) et la seconde section (3b), pour mettre en compression la seconde section (3b) de la couche principale ; la couche intercalaire (4) étant composée :
• d'une couche inférieure (4a) disposée sur la première section (3a) de la couche principale (3) ;
• et, disposée sur et en contact avec la couche inférieure (4a), d'une couche supérieure (4b) constituée d'un super réseau ; la couche inférieure (4a) étant constituée d'une couche homogène ou d'un super réseau différent du super réseau constituant la couche supérieure (4b), présentant une densité de dislocation supérieure à celle de la couche supérieure (4b) et un paramètre de maille plus petit que le paramètre de maille du matériau formant la couche supérieure (4b), le super réseau constituant la couche supérieure (4b) et, le cas échéant, le super réseau constituant la couche inférieure (4a), étant formé(s) d'une répétition d'un motif comprenant au moins deux couches de natures différentes, la structure semi-conductrice à base de matériaux III-N étant **caractérisé en ce que** chaque couche composant le motif présente une 35 épaisseur comprise entre 0,5 nm et 50 nm, la couche intercalaire présente une épaisseur comprise entre 200 nm et 1000 nm, et la couche supérieure comprend un dopant de type p de carbone, de fer ou de magnésium dans une concentration comprise entre 5X 10¹⁸ et 5X 10¹⁹ at/cm³ pour la rendre résistive.

2. Structure semi-conductrice (1) selon la revendication précédente dans lequel paramètre de maille du matériau formant la couche supérieure (4b) est plus petit que le paramètre de maille du matériau formant la seconde section (3b) de la couche principale (3).

3. Structure semi-conductrice (1) selon l'une des revendications précédentes dans laquelle la couche principale (3) et la couche intercalaire (4) sont monocristallines.

4. Structure semi-conductrice (1) selon l'une des revendications précédentes comportant une seconde couche intercalaire (4c) sur la seconde section (3b) de la couche principale (3) et une troisième section (3c) de la couche principale disposée sur la seconde couche intercalaire (4c).

5. Structure semi-conductrice (1) selon la revendication précédente dans laquelle la seconde couche intercalaire est composée d'une couche homogène, d'un super réseau, ou d'une combinaison de tels éléments.

6. Structure semi-conductrice (1) selon l'une des revendications précédentes dans laquelle le substrat support (2) présente un coefficient de dilatation thermique inférieur à celui de la couche principale (3).

7. Plaquette de semi-conducteur comprenant une structure semi-conductrice (1) selon l'une des revendications précédentes.

8. Dispositif intégré comprenant une structure semi-conductrice (1) selon l'une des revendications précédentes.

9. Procédé de fabrication d'une structure semi-conductrice (1) à base de matériaux III-N sur un substrat support (2), le procédé comprenant :
a. la formation d'une couche principale (3) en matériau III-N sur le substrat support (2) la couche principale (3) comportant une première section (3a) et une deuxième section (3b) disposée sur la première section ;
b. la formation d'une couche intercalaire (4) en matériau III-N disposée entre la première section (3a) et la seconde section (3b), la couche intercalaire (4) présentant une épaisseur comprise entre 200 nm et 1000nm pour mettre en compression la seconde section (3b) de la couche principale ; la formation de la couche intercalaire (4) comprenant :
- la formation, à une première température, d'une couche inférieure (4a) disposée sur la première section (3a) de la couche principale (3) ;
- et, la formation, à une seconde température, d'une couche supérieure (4b) constituée d'un super réseau et disposée sur et en contact avec la couche inférieure (4a); la première température étant inférieure à la seconde température, la couche inférieure (4a) étant constituée d'une couche homogène ou d'un super réseau différent du super réseau constituant la couche supérieure (4b), la couche inférieure (4a) présentant un paramètre de maille plus petit que le paramètre de maille du matériau formant la couche supérieure (4b), le super réseau constituant la couche supérieure (4b) et, le cas échéant, le super réseau constituant la couche inférieure (4a), étant formé(s) d'une répétition d'un motif comprenant au moins deux couches de natures différentes, le procédé de fabrication de la structure semi-conductrice à base de matériaux III-N étant **caractérisé en ce que** chaque couche composant le motif présente une épaisseur comprise entre 0,5 nm et 50 nm, la couche intercalaire présente une épaisseur comprise entre 200 nm et 1000 nm, et la couche supérieure comprend un dopant de type p de carbone, de fer ou de magnésium dans une concentration comprise entre 5X 10¹⁸ et 5X 10¹⁹ at/cm³ pour la rendre résistive.

10. Procédé selon la revendication précédente dans lequel la première température est inférieure à 1000°C.

11. Procédé selon l'une des revendications 9 et 10 dans lequel la seconde température est comprise entre 1050 et 1100°C.

## Patentansprüche

1. Halbleiterstruktur (1) auf der Basis von III-N-Materialien, umfassend:
• ein Trägersubstrat (2);
• eine Hauptschicht (3) aus III-N-Material, wobei die Hauptschicht (3) einen ersten Abschnitt (3a), der auf dem Trägersubstrat (2) angeordnet ist, und einen zweiten Abschnitt (3b), der auf dem ersten Abschnitt (3a) angeordnet ist, aufweist;
• eine Zwischenschicht (4) aus III-N-Material, die zwischen dem ersten Abschnitt (3a) und dem zweiten Abschnitt (3b) angeordnet ist, um den zweiten Abschnitt (3b) der Hauptschicht zu komprimieren;
wobei die Zwischenschicht (4) zusammengesetzt ist aus:
• einer unteren Schicht (4a), die auf dem ersten Abschnitt (3a) der Hauptschicht (3) angeordnet ist;
• und, angeordnet auf und in Kontakt mit der unteren Schicht (4a), einer oberen Schicht (4b), die aus einem Übergitter besteht;
wobei die untere Schicht (4a) aus einer homogenen Schicht oder aus einem Übergitter besteht, das sich von dem die obere Schicht (4b) bildenden Übergitter unterscheidet und eine Versetzungsdichte, die größer ist als die der oberen Schicht (4b), und einen Maschenparameter aufweist, der kleiner ist als der Maschenparameter des die obere Schicht (4b) bildenden Materials, wobei das die obere Schicht (4b) bildende Übergitter und gegebenenfalls das die untere Schicht (4a) bildende Übergitter aus einer Wiederholung eines Musters gebildet ist (sind), das mindestens zwei Schichten unterschiedlicher Beschaffenheit umfasst, wobei die Halbleiterstruktur auf der Basis von III-N-Materialien **dadurch gekennzeichnet ist, dass** jede Schicht, die das Muster bildet, eine Dicke zwischen 0,5 nm und 50 nm aufweist, dass die Zwischenschicht eine Dicke zwischen 200 nm und 1000 nm aufweist und dass die obere Schicht einen p-Dotierstoff aus Kohlenstoff, Eisen oder Magnesium in einer Konzentration zwischen 5 x 10¹⁸ und 5 x 10¹⁹ at/cm³ umfasst, um sie resistiv zu machen.

2. Halbleiterstruktur (1) nach dem vorhergehenden Anspruch, wobei der Maschenparameter des Materials, das die obere Schicht (4b) bildet, kleiner ist als der Maschenparameter des Materials, das den zweiten Abschnitt (3b) der Hauptschicht (3) bildet.

3. Halbleiterstruktur (1) nach einem der vorhergehenden Ansprüche, wobei die Hauptschicht (3) und die Zwischenschicht (4) monokristallin sind.

4. Halbleiterstruktur (1) nach einem der vorhergehenden Ansprüche mit einer zweiten Zwischenschicht (4c) auf dem zweiten Abschnitt (3b) der Hauptschicht (3) und einem dritten Abschnitt (3c) der Hauptschicht, der auf der zweiten Zwischenschicht (4c) angeordnet ist.

5. Halbleiterstruktur (1) nach dem vorhergehenden Anspruch, wobei die zweite Zwischenschicht aus einer homogenen Schicht, einem Übergitter oder einer Kombination solcher Elemente besteht.

6. Halbleiterstruktur (1) nach einem der vorhergehenden Ansprüche, wobei das Trägersubstrat (2) einen niedrigeren Wärmeausdehnungskoeffizienten als die Hauptschicht (3) aufweist.

7. Halbleiterwafer, umfassend eine Halbleiterstruktur (1) nach einem der vorhergehenden Ansprüche.

8. Integrierte Vorrichtung, umfassend eine Halbleiterstruktur (1) nach einem der vorhergehenden Ansprüche.

9. Verfahren zur Herstellung einer Halbleiterstruktur (1) auf der Basis von III-N-Materialien auf einem Trägersubstrat (2), wobei das Verfahren Folgendes umfasst:
a. Bilden einer Hauptschicht (3) aus III-N-Material auf dem Trägersubstrat (2), wobei die Hauptschicht (3) einen ersten Abschnitt (3a) und einen zweiten Abschnitt (3b), der auf dem ersten Abschnitt angeordnet ist, aufweist;
b. Bilden einer Zwischenschicht (4) aus III-N-Material, die zwischen dem ersten Abschnitt (3a) und dem zweiten Abschnitt (3b) angeordnet ist, wobei die Zwischenschicht (4) eine Dicke zwischen 200 nm und 1000 nm aufweist, um den zweiten Abschnitt (3b) der Hauptschicht zu komprimieren;
wobei das Bilden der Zwischenschicht (4) Folgendes umfasst:
- Bilden, bei einer ersten Temperatur, einer unteren Schicht (4a), die auf dem ersten Abschnitt (3a) der Hauptschicht (3) angeordnet ist;
- und Bilden, bei einer zweiten Temperatur, einer oberen Schicht (4b), die aus einem Übergitter besteht und auf und in Kontakt mit der unteren Schicht (4a) angeordnet ist;
wobei die erste Temperatur niedriger ist als die zweite Temperatur, wobei die untere Schicht (4a) aus einer homogenen Schicht oder aus einem Übergitter besteht, das sich von dem die obere Schicht (4b) bildenden Übergitter unterscheidet, wobei die untere Schicht (4a) einen kleineren Maschenparameter aufweist als der Maschenparameter des die obere Schicht (4b) bildenden Materials, wobei das die obere Schicht (4b) bildende Übergitter und gegebenenfalls das die untere Schicht (4a) bildende Übergitter aus einer Wiederholung eines Musters gebildet ist (sind), das mindestens zwei Schichten unterschiedlicher Beschaffenheit umfasst, wobei das Verfahren zur Herstellung der Halbleiterstruktur auf der Basis von III-N-Materialien **dadurch gekennzeichnet ist, dass** jede Schicht, die das Muster bildet, eine Dicke zwischen 0,5 nm und 50 nm aufweist, dass die Zwischenschicht eine Dicke zwischen 200 nm und 1000 nm aufweist und dass die obere Schicht einen p-Dotierstoff aus Kohlenstoff, Eisen oder Magnesium in einer Konzentration zwischen 5 x 10¹⁸ und 5 x 10¹⁹ at/cm³ umfasst, um sie resistiv zu machen.

10. Verfahren nach dem vorhergehenden Anspruch, wobei die erste Temperatur weniger als 1000 °C beträgt.

11. Verfahren nach einem der Ansprüche 9 und 10, wobei die zweite Temperatur zwischen 1050 und 1100 °C liegt.

## Claims

1. Semiconductor structure (1) based on III-N materials, comprising:
• a support substrate (2);
• a main layer (3) made of III-N material, the main layer (3) comprising a first section (3a) arranged on the support substrate (2) and a second section (3b) arranged on the first section (3a);
• an intermediate layer (4) made of III-N material and arranged between the first section (3a) and the second section (3b), for compressing the second section (3b) of the main layer;
the intermediate layer (4) consisting of:
• a lower layer (4a) arranged on the first section (3a) of the main layer (3);
• and, arranged on and in contact with the lower layer (4a), an upper layer (4b) consisting of a superlattice;
the lower layer (4a) consisting of a homogeneous layer or a superlattice which is different from the superlattice constituting the upper layer (4b), having a dislocation density greater than that of the upper layer (4b) and a mesh parameter smaller than the mesh parameter of the material forming the upper layer (4b), the superlattice constituting the upper layer (4b) and, where appropriate, the superlattice constituting the lower layer (4a) being formed by a repetition of a pattern comprising at least two layers of different types, the semiconductor structure based on III-N materials being **characterized in that** each layer making up the pattern has a thickness of between 0.5 nm and 50 nm, the intermediate layer has a thickness of between 200 nm and 1000 nm, and the upper layer comprises a p-type dopant of carbon, iron or magnesium in a concentration of between 5×10¹⁸ and 5×10¹⁹ at/cm³ in order to make said layer resistive.

2. Semiconductor structure (1) according to the preceding claim, wherein the mesh parameter of the material forming the upper layer (4b) is smaller than the mesh parameter of the material forming the second section (3b) of the main layer (3).

3. Semiconductor structure (1) according to either of the preceding claims, wherein the main layer (3) and the intermediate layer (4) are monocrystalline.

4. Semiconductor structure (1) according to any of the preceding claims, comprising a second intermediate layer (4c) on the second section (3b) of the main layer (3) and a third section (3c) of the main layer arranged on the second intermediate layer (4c).

5. Semiconductor structure (1) according to the preceding claim, wherein the second intermediate layer consists of a homogeneous layer, a superlattice, or a combination of elements of this kind.

6. Semiconductor structure (1) according to any of the preceding claims, wherein the support substrate (2) has a coefficient of thermal expansion that is less than that of the main layer (3).

7. Semiconductor wafer comprising a semiconductor structure (1) according to any of the preceding claims.

8. Integrated device comprising a semiconductor structure (1) according to any of the preceding claims.

9. Method for producing a semiconductor structure (1) based on III-N materials on a support substrate (2), the method comprising:
a. forming a main layer (3) made of III-N material on the support substrate (2), the main layer (3) comprising a first section (3a) and a second section (3b) arranged on the first section;
b. forming an intermediate layer (4) made of III-N material and arranged between the first section (3a) and the second section (3b), the intermediate layer (4) having a thickness of between 200 nm and 1000 nm in order to compress the second section (3b) of the main layer;
the formation of the intermediate layer (4) comprising:
- forming, at a first temperature, a lower layer (4a) arranged on the first section (3a) of the main layer (3);
- and forming, at a second temperature, an upper layer (4b) consisting of a superlattice and arranged on and in contact with the lower layer (4a);
the first temperature being lower than the second temperature, the lower layer (4a) consisting of a homogeneous layer or a superlattice which is different from the superlattice constituting the upper layer (4b), the lower layer (4a) having a mesh parameter smaller than the mesh parameter of the material forming the upper layer (4b), the superlattice constituting the upper layer (4b) and, where appropriate, the superlattice constituting the lower layer (4a) being formed by a repetition of a pattern comprising at least two layers of different types, the method for producing the semiconductor structure based on III-N materials being **characterized in that** each layer making up the pattern has a thickness of between 0.5 nm and 50 nm, the intermediate layer has a thickness of between 200 nm and 1000 nm, and the upper layer comprises a p-type dopant of carbon, iron or magnesium in a concentration of between 5x10¹⁸ and 5x10¹⁹ at/cm³ in order to make said layer resistive.

10. Method according to the preceding claim, wherein the first temperature is less than 1000°C.

11. Method according to either claim 9 or claim 10, wherein the second temperature is between 1050 and 1100°C.
